(19) **Europäisches Patentamt / European Patent Office / Office européen des brevets**

(11) **EP 1 645 887 B1**

(12) **EUROPEAN PATENT SPECIFICATION**

(45) Date of publication and mention
of the grant of the patent:
**26.09.2007 Bulletin 2007/39**

(51) Int Cl.:
**G01R 31/12** *(2006.01)*

(21) Application number: **05109329.2**

(22) Date of filing: **07.10.2005**

(54) **Instrument for detecting and analysing partial discharges in electrical machines**

Messgerät zum Nachweis und Analyse von Teilentladungen in elektrischen Maschinen

Instrument pour la détection et l'analyse de décharges partielles dans des machines électriques

(84) Designated Contracting States:
**AT BE BG CH CY CZ DE DK EE ES FI FR GB GR HU IE IS IT LI LT LU LV MC NL PL PT RO SE SI SK TR**

(30) Priority: **08.10.2004 IT TO20040687**

(43) Date of publication of application:
**12.04.2006 Bulletin 2006/15**

(73) Proprietor: **ANSALDO ENERGIA S.P.A.**
**16152 Genova (IT)**

(72) Inventors:
• **Gandolfi, Paolo**
**16129 Genova (IT)**
• **Oldrati, Alessandro**
**16129 Genova (IT)**

(74) Representative: **Jorio, Paolo et al**
**Studio Torta S.r.l.**
**Via Viotti, 9**
**10121 Torino (IT)**

(56) References cited:
**US-A- 4 710 705          US-B1- 6 452 416**

• **PATENT ABSTRACTS OF JAPAN vol. 013, no. 250 (P-882), 12 June 1989 (1989-06-12) -& JP 01 049984 A (HITACHI LTD), 27 February 1989 (1989-02-27)**
• **CHANGCHANG WANG ET AL: "Analysis and suppression of continuous periodic interference for on-line PD monitoring of power transformers" HIGH VOLTAGE ENGINEERING, 1999. ELEVENTH INTERNATIONAL SYMPOSIUM ON (CONF. PUBL. NO. 467) LONDON, UK 23-27 AUG. 1999, LONDON, UK,IEE, UK, vol. 5, 23 August 1999 (1999-08-23), pages 212-215, XP006501758 ISBN: 0-85296-719-5**

Printed by Jouve, 75001 PARIS (FR)

**Description**

The present invention relates to an instrument for detecting and analysing partial discharges in electrical machines.

As it is known, electrical machines (principally alternators, electrical motors and transformers) comprise, among other things, electrical windings which are accommodated in seats made in metallic structures, for example metallic structures formed by a plurality of overlapped metal foils.

The electrical windings are made of filiform or flat conductors of metallic material (generally copper) coated by an insulating sheath; the winding is insulated using insulating winding tapes and/or insulating resins which envelop the set of conductors.

It is also known that, due to faults present in the insulation (for example microscopic cavities), there may be created electrical discharges, called precisely partial discharges, which are developed between the winding and the metallic structure which is connected to an earth potential.

The presence of such partial electrical discharges is a potentially detrimental phenomenon, which must be carefully assessed.

For this purpose, there have been developed instruments for detecting partial discharges.

A first category of known detecting instruments employs an **offline** type measurement, that is the measurement is made with the electrical machine disconnected from the electrical mains and "stopped", that is not operating.

Such detection instruments require the powering on one (or more) winding(s) of the electrical machine through an external source of power which supplies a generally adjustable reference voltage. The known instruments use a capacitive/resistive voltage divider arranged between the winding under test and a reference potential and measure the voltage pulses present on the resistive element to measure the presence/intensity of the partial discharges.

A second category of known detecting instruments employs an **online** type measurement, that is the measurement is made with the electrical machine connected to the electrical line (operating electrical machine).

For the online type of measurement it is used a pair of capacitive/resistive voltage dividers arranged between the phase of the winding under test and a reference potential (earth potential); also in this case it is detected the intensity of the voltage pulses present on the resistive element to measure the presence/intensity of the partial discharges.

The advantage of using the online type instruments is in that, to conduct the tests, it is not necessary to stop the electrical machine and therefore the measurement does not interfere with the operativeness of the electrical machine. Furthermore, the online type measurement allows to verify the state of the insulation in real conditions of use in which there are present all the stresses (electrical, thermal, mechanical) which are presented during the usual use of the electrical machine.

The document JP-A-01049984 discloses a partial discharge diagnosing device for transformers in which the soundness of an ultrasonic vibration, obtained from the partial discharge peak, is sensed. When two consecutive peaks occur in an interval smaller than a certain threshold, it is judged that a discharge in the transformer has occurred.

It is the object of the present invention to obtain an instrument for detecting and analysing partial discharges in electrical machines which is particularly effective and simple to use.

The preceding object is reached by the present invention in that it relates to an instrument for detecting and analysing partial discharges of the type described in claim 1.

The invention will now be explained with particular reference to the accompanying drawings which show a preferred non-limitative embodiment thereof, in which:

- figure 1 shows a simplified wiring diagram of an instrument for detecting and analysing partial discharges in electrical machines obtained according to the dictates of the present invention; and
- figures 2 and 3 show variables elaborated from the instrument obtained according to the present invention.

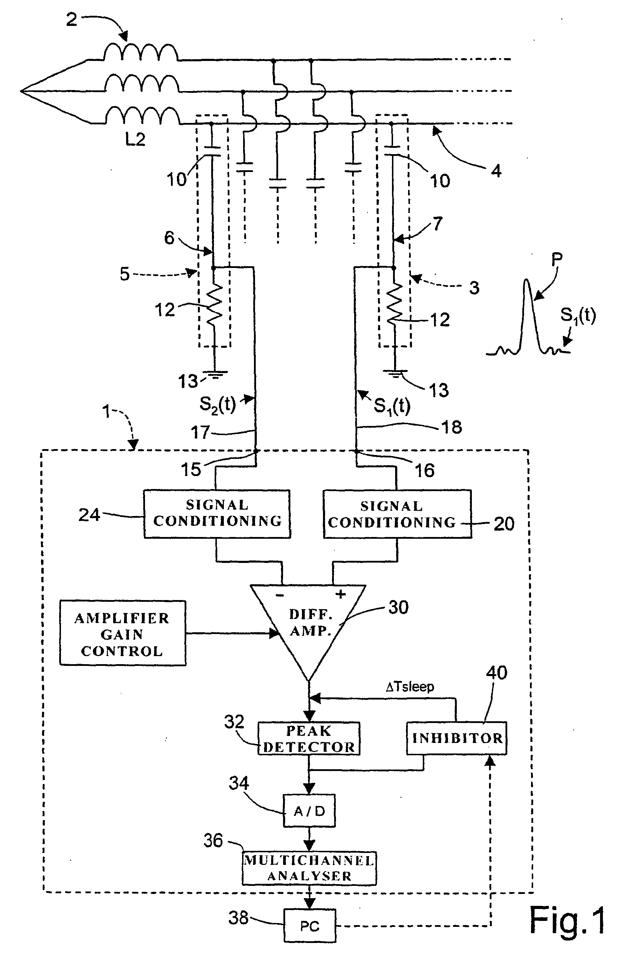

In figure 1 it is indicated by 1, as a whole, an instrument for detecting and analysing partial discharges in electrical machines 2 obtained according to the dictates of the present invention.

The instrument 1, achieving measurements of the online type, is provided with a first partial discharge sensor 3 (of the known type) adapted to be coupled to an electrical line 4 connected to a phase (in the example a winding L2) of the electrical machine 2 under test (for example a three phase generator) to pick up a signal S1(t) in which there are detectable peaks associated to partial discharges.

The instrument 1 is also provided with a second partial discharge sensor 5 (of the known type) adapted to be coupled directly to the winding L2 of the electrical machine 2 to pick up a signal S2(t) in which are detectable peaks associated to partial discharges.

Each sensor 3, 5 includes a capacitor 10 presenting a first end connected to a terminal of the winding L2, to the electrical line 4 and a second end connected, through a respective conductor 7 and 6, to a first terminal of a resistor 12 having, in turn, a second terminal connected to a reference potential 13 (earth). The conductors 6 and 7 present reciprocally different lengths - such lengths are defined during the calibration step of the instrument 1.

At the ends of the first terminal of each resistor 12 it is picked up the signal s1(t), s2(t) which is sent to inputs 16 and 15 of the instrument 1 through respective electrical wires 18 and 17 presenting equal length.

The signals s1(t), s2(t) present a series of ripples in which is detectable at least one peak P at the emission of a partial discharge within the insulation of the winding of the electrical machine 2 (figure 1, detail).

As shown above, the sensors 5 and 3 form capacitive/resistive voltage dividers which are arranged between the winding L2/the electrical line 4 and the reference potential 13. The signals S1(t) and S2(t) present at the inputs 16 and 15 are also reciprocally offset in time due to the different length of the conductors 7 and 6. Consequently, a first and a second peak associated to the emission of the same partial discharge are reciprocally offset in time on two different signals s1(t) and s2(t).

The instrument 1 comprises:

- a first conditioner circuit of the mains signal 20 (of the known type) which receives the input signal s1(t) and which is adapted to amplify and form it;
- a second conditioner circuit of the mains signal 24 (also of the known type) which receives the input signal s2(t) and which is adapted to amplify and form it;
- a programmable variable gain differential amplifier 30 which receives at its inputs the output signals from the two circuits 20, 24 and is adapted to suppress the common mode noise, in particular to eliminate the interference from the electrical line 4. The gain variation allows to vary the full-scale of the instrument 1 adapting it to the intensity of the partial discharges on the winding;
- a peak detecting circuit 32 receiving the input signal S1-S2(t) filtered in output by the differential amplifier 30;
- an analogue digital converter 34 receiving as input the output signal of the peak detector circuit 32;
- a multichannel analyser 36 receiving as input the digitised output signal of the digital analogue converter 34; the multichannel analyser 36 measures the maximum value of the digitised peaks which are presented in sequence at its input and increases, at the detection of each peak, by one unit the content of a memory cell (channel) whose address is equal to the binary value of the detected partial discharge intensity; and
- a control block 38 of the instrument 1 (conveniently consisting of a personal computer) usable by a user and connected to the multichannel analyser 36.

According to the present invention it is envisaged an inhibiting circuit 40 coupled with the peak detector circuit 32 and is adapted to perform the following function:

following the detection of a first peak by the peak detector 22 it is inhibited the detection of peaks by the same peak detector 32 for a silencing interval Δ**Tsleep** adjustable at will by the operator by means of the control block 38.

As pointed out above, at the emission of a partial discharge, the two signals S1 and S2 (t) are reciprocally offset in time by a delay time interval Δ**Tret** which mainly depends on the different courses followed by the signals themselves along the conductors 6, 7 whose lengths - as shown above - are reciprocally different.

By adjusting the silencing interval Δ**Tsleep** so that it is longer than the delay time interval Δ**Tret,** it is avoided the double detection of the same peak (with reversed polarity) on the two different signals, making more simply the subsequent processing operation performed by the multichannel analyser 36. The detection of a partial discharge corresponds precisely to the detection of a peak because, as mentioned above, the partial discharge corresponds to a rapid ripple of the signal s1(t), s2(t).

The interference from the outside of the electrical machine 2 reach instead the inputs of the differential amplifier 30 in the same instant and are however eliminated by the differential filtering.

The instrument is therefore capable of a discriminating between interference coming from outside the electrical machine and the signal related to the partial discharges generated inside the electrical machine.

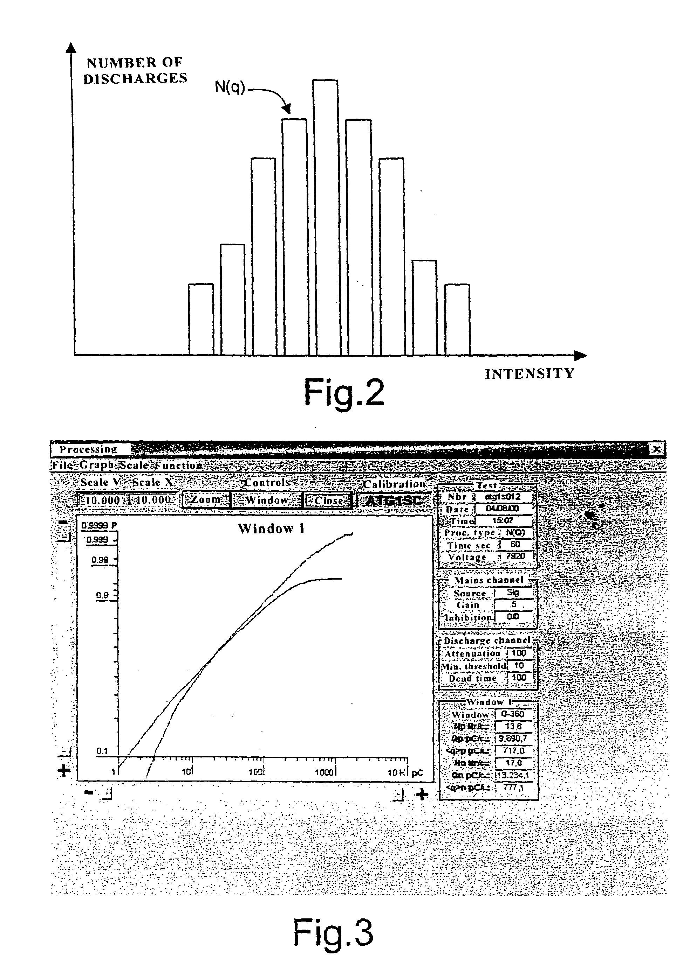

The multichannel processor 36, according to a preferred embodiment of the present invention, performs a graphical representation of the detected data where on ordinate it is shown the number of partial discharges counted in the acquisition time and on abscissa there may be shown the discharge intensity (graph N(q)); it is thus provided a bar chart which shows the frequency of the partial discharges for different intensity values (figure 2).

Alternatively, on abscissa it may be shown the 50 Hz sinusoidal phase in which there are detected the single partial discharge events (graph N(V)).

A further aspect of the present invention is constituted by the possibility of representing the density of probability of the partial discharge event according to the Weibull function:

$$N(q) = \frac{\beta}{\alpha^\beta}(q-\gamma)^{\beta-1}e^{-(\frac{(q-\gamma)}{\alpha})^\beta} \quad (1)$$

In said function,

-   N is the number of partial discharges detected for a determined value of the load q, which represents the intensity of the partial discharges expressed in picoCoulomb,
-   $\alpha$ is the scale parameter or "characteristic load" which provides a term of comparison between different detections,
-   $\beta$ shows the shape parameter which indicates the value of the values dispersion of the distribution curve around the value $\alpha$,
-   $\gamma$ is defined as the "trigger level" and in particular $\gamma$ has the same units of measure of q and indicates by how much the distribution is shifted with respect to zero and, consequently, identifies a threshold value under which there is no partial discharge value.

By means of the formula (1) it is obtained a numeric representation of the amplitude distribution which is displayed by the device 1.

For distributions of amplitude of the partial discharges referred to new stators, the value of $\beta$ must be close to 0.5, because otherwise there would be manufacturing faults inside the stators themselves: indeed, in the presence of superficial discharges on the involutes, $\beta$ tends to 1, while, if there are present discharge in slot phenomena, $\beta$ assumes values higher than 1 (in consideration of the fact that to the normal partial discharge activity inside vacuoles uniformity distributed in the insulating wall there are overlapped activities concentrated in vacuoles of larger size due for example to delaminations between the layers of the insulating wall).

The device according to the present invention is also adapted to provide a Weibull cumulative chart (see figure 3), where, on abscissa, it is shown the intensity of the partial discharges (PD) on logarithmic axis, while, on ordinate, it is shown the integral of the function N(q).

## Claims

1.  An instrument for detecting and analysing partial discharges in electrical machines comprising:

    • a first sensor and a second sensor (3, 5) adapted to be coupled with at least one winding of an electrical machine (2) under test to pick up respective signals S1(t) and S2(t) which are routed along propagation courses (7, 6) having different lengths;
    • a differential amplifier (30) which receives at its inputs the signals from said sensors (3, 5) and outputs a signal proportional to the difference s1(t)-s2(t) between the signals picked up at the end (16, 17) of the respective propagation courses,
    • a peak detector circuit (32) which receives an input signal proportional to said difference s1(t)-s2(t);

    **characterised in that** it comprises an inhibitor circuit (35) coupled with a peak detector circuit (32) and adapted to perform the following function:

    following the detection of a first peak by the peak detector (32) corresponding to the detection of a partial discharge it is inhibited the detection of peaks by the same peak detector for a silencing interval $\Delta$**Tsleep**.

2.  - An instrument according to claim 1, in which said silencing interval $\Delta$**Tsleep** is of the adjustable type.

3.  An instrument according to claim 1, in which said differential amplifier has adjustable gain.

4.  - An instrument according to claim 1, in which there are envisaged signal conditioner circuits (20, 24) arranged between said sensors (3, 5) and the inputs of said differential amplifier (30) and adapted to amplify and form the respective input signal supplied to each signal conditioner circuit (20, 24).

5.  - An instrument according to claim 1, in which it is provided an analogue digital converter (34) connected in input to the output of said peak detector (32) and a multichannel analyser (36) connected in input to an output of said analogue digital converter (34).

6. An instrument according to claim 5, in which said multichannel analyser (36) measures the maximum value of the digitised peaks increasing of a unit, at the detection of each peak, the content of a memory cell (channel) whose address is equal to the binary value of the detected partial discharge intensity.

7. An instrument according to claim 1, in which it is envisaged a multichannel analyser (36) which runs a statistical analysis on the detected data by calculating and displaying the density of probability of the partial discharge identification event according to the Weibull function:

$$N(q) = \frac{\beta}{\alpha^{\beta}}(q-\gamma)^{\beta-1}e^{-(\frac{(q-\gamma)}{\alpha})\beta} \quad (1)$$

where:

- N is the number of partial discharges detected for a determined value of the load q, which represents the intensity of the partial discharges expressed in picoCoulomb,
- $\alpha$ is the scale parameter which provides a term of comparison between different detections,
- $\beta$ shows the shape parameter which indicates the value of the values dispersion of the distribution curve around the value $\alpha$,
- $\gamma$ defines a "trigger level" adapted to indicate how much the distribution has shifted with respect to zero.

8. - An instrument according to claim 7, in which it is supplied a cumulative Weibull chart Cartesian representation in which:

on abscissa it is shown the intensity of the partial discharges (PD) in logarithmic axis; and
on ordinate it is shown the integral of the N(q) function.

**Patentansprüche**

1. Instrument zum Detektieren und Analysieren von Teilentladungen in elektrischen Maschinen umfassend:

• einen ersten Sensor und einen zweiten Sensor (3, 5), die dafür eingerichtet sind, an wenigstens eine Wicklung einer zu testenden elektrischen Maschine (2) angeschlossen zu werden, um Signale s1(t) bzw. s2(t) zu erfassen, die entlang Übertragungswegen (7, 6) mit unterschiedlichen Längen geleitet werden;
• einen Differenzverstärker (30), der an seinen Eingängen die Signale von den Sensoren (3, 5) empfängt und der ein Signal ausgibt, das proportional zur Differenz s1(t) - s2(t) zwischen den am Ende (16, 17) der jeweiligen Übertragungswege erfaßten Signalen ist;
• eine Spitzenwert-Detektionsschaltung (32), die ein Eingangssignal erhält, das proportional zur Differenz s1(t) - s2(t) ist;

**dadurch gekennzeichnet, daß** es eine Unterdrückungsschaltung (35) umfaßt, die mit einer Spitzenwert-Detektionsschaltung (32) verbunden ist und die dafür eingerichtet ist, die folgende Funktion auszuführen:

nach der Detektion eines ersten Spitzenwerts durch den Spitzenwertdetektor (32), was der Detektion einer Teilentladung entspricht, wird die Detektion von Spitzenwerten durch denselben Spitzenwertdetektor für ein Ruheintervall ∆Tsleep unterdrückt.

2. Instrument nach Anspruch 1, bei dem das Ruheintervall ∆Tsleep vom einstellbaren Typ ist.

3. Instrument nach Anspruch 1, bei dem der Differenzverstärker eine einstellbare Verstärkung hat

4. Instrument nach Anspruch 1, bei dem Signalbearbeitungsschaltungen (20, 24) vorgesehen sind, die zwischen den Sensoren (3, 5) und den Eingängen des Differenzverstärkers (30) angeordnet sind und die dafür eingerichtet sind, das jeweilige Eingangssignal, das auf jede Signalbearbeitungsschaltung (20, 24) gegeben wird, zu verstärken und zu formen.

**5.** Instrument nach Anspruch 1, das einen Analog-Digital-Wandler (34) umfaßt, der eingangsseitig mit dem Ausgang des Spitzenwertdetektors (32) verbunden ist, sowie einen Mehrkanal-Analysator (36), der eingangsseitig mit einem Ausgang des Analog-Digital-Wandlers (34) verbunden ist.

**6.** Instrument nach Anspruch 5, bei dem der Mehrkanal-Analysator (36) den Maximalwert der digitalisierten Spitzenwerte mißt, wobei er bei der Detektion jedes Spitzenwerts den Inhalt einer Speicherzelle (Kanal), deren Adresse gleich dem binären Wert der detektierten Teilentladungsintensfät ist, um eine Einheit erhöht.

**7.** Instrument nach Anspruch 1, bei dem ein Mehrkanal-Analysator (36) vorgesehen ist, der auf den detektierten Daten eine statistische Analyse ausführt, indem er die Wahrscheinlichkeitsdichte des die Teilentladung kennzeichnenden Ereignisses entsprechend der Weibull-Funktion berechnet und anzeigt:

$$N(q) = \frac{\beta}{\alpha^\beta} (q - \gamma)^{\beta-1} e^{-\left(\frac{(q-\gamma)}{\alpha}\right)\beta} \qquad (1)$$

wobei:

- N die Anzahl der Teilentladungen ist, die für einen bestimmten Wert der Last q detektiert werden, welche die Intensität der Teilentladungen ausgedrückt in Pikocoulomb repräsentiert,
- $\alpha$ der Skalenparameter ist, der einen Vergleichsfaktor zwischen verschiedenen Detektionen bereitstellt,
- $\beta$ den Formparameter darstellt, der den Wert der Streuung der Werte der Verteilungskurve um den Wert $\alpha$ herum angibt,
- $\gamma$ einen "Trigger-Pegel" festlegt, der dafür eingerichtet ist, anzuzeigen wie weit die Verteilung in Bezug auf den Nullpunkt verschoben ist.

**8.** Instrument nach Anspruch 7, bei dem eine kartesische kumulative Weibull Diagrammdarstellung bereitgestellt wird, bei der:

auf der Abszisse die Intensität der Teilentladungen (PD) mit einer logarithmischen Skala aufgetragen ist; und auf der Ordinate das Integral der N(q)-Funktion aufgetragen ist.

**Revendications**

**1.** Instrument de détection et d'analyse de décharges partielles dans des machines électriques comprenant :

• un premier capteur et un second capteur (3, 5) adaptés pour être couplés à au moins un bobinage d'une machine électrique (2) sous test pour recueillir des signaux respectifs S1(t) et S2(t) qui sont acheminés le long des trajets de propagation (7, 6) présentant différentes longueurs;
• un amplificateur différentiel (30) recevant à ses entrées les signaux desdits capteurs (3, 5) et émettant un signal proportionnel à la différence S1(t)-S2(t) entre les signaux recueillis à l'extrémité (16, 17) des trajets de propagation respectifs,
• un circuit de détection de crête (32) qui reçoit un signal d'entrée proportionnel à ladite différence S1(t)-S2(t);

**caractérisé en ce qu'**il comprend un circuit inhibiteur (35) couplé à un circuit de détection de crête (32) et adapté pour exécuter la fonction suivante :

à la suite de la détection d'une première crête par le détecteur de crêtes (32) correspondant à la détection d'une décharge partielle, la détection de crêtes par le même détecteur de crêtes est inhibée durant un intervalle de sommeil ΔTsommeil.

**2.** Instrument selon la revendication 1, dans lequel ledit intervalle de sommeil ΔTsommeil est du type réglable.

**3.** Instrument selon la revendication 1, dans lequel ledit amplificateur différentiel a un gain réglable.

**4.** Instrument selon la revendication 1, dans lequel sont prévus des circuits de conditionnement de signal (20, 24) disposés entre lesdits capteurs (3, 5) et les entrées dudit amplificateur différentiel (30) et adaptés pour amplifier et former le signal d'entrée respectif fourni à chaque circuit de conditionnement de signal (20, 24).

**5.** Instrument selon la revendication 1, dans lequel est prévu un convertisseur analogique numérique (34) relié en entrée à la sortie dudit détecteur de crêtes (32) et un analyseur à canaux multiples (36) relié en entrée à une sortie dudit convertisseur analogique numérique (34).

**6.** Instrument selon la revendication 5, dans lequel ledit analyseur à canaux multiples (36) mesure la valeur maximale des crêtes numérisées augmentant d'une unité, à la détection de chaque crête, le contenu d'une cellule mémoire (canal) dont l'adresse est égale à la valeur binaire de l'intensité des décharges partielles détectées.

**7.** Instrument selon la revendication 1, dans lequel est prévu un analyseur à canaux multiples (36) qui exécute une analyse statistique sur les données détectées en calculant et affichant la densité de probabilité de l'événement d'identification de décharge partielle selon la fonction de Weibull :

$$N(q) = \frac{\beta}{\alpha^{\beta}}(q-\gamma)^{\beta-1} e^{-(\frac{(q-\gamma)}{\alpha})^{\beta}} \quad (1)$$

où :

- N est le nombre de décharges partielles détectées pour une valeur déterminée de la charge q, qui représente l'intensité des décharges partielles exprimées en picoCoulomb,
- $\alpha$ est le paramètre d'échelle qui offre un terme de comparaison entre différentes détections,
- $\beta$ indique le paramètre de forme qui indique la valeur de la dispersion de valeurs de la courbe de distribution autour de la valeur $\alpha$,
- $\gamma$ définit un « niveau de déclenchement» adapté pour indiquer dans quelle mesure la distribution a été décalée par rapport à zéro.

**8.** Instrument selon la revendication 7, dans lequel est effectuée une représentation cartésienne cumulative du diagramme de Weibull, dans laquelle :

sur l'abscisse, est représentée l'intensité des décharges partielles (PD) sur l'axe logarithmique ; et
sur l'ordonnée, est représentée l'intégrale de la fonction N(q).

Fig.1

Fig.2

Fig.3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 01049984 A